# DEMANDE DE BREVET EUROPEEN

(11) **EP 4 783 788 A1**
(43) Date de publication de la demande: **29.07.2026**
(21) Numéro de dépôt: 26152418.5
(22) Date de dépôt: 16.01.2026
(51) Int. Cl.: H10H 20/01, H10H 20/817, H10H 20/819, H10H 20/855

(54) **PROCÉDÉ DE FABRICATION D'UN SYSTÈME ÉMISSIF**

(30) Priorité: 24.01.2025 FR 2500738
(71) Demandeur: Commissariat à l'Energie Atomique et aux Energies Alternatives, 75015 Paris (FR)
(72) Inventeur: ABADIE, Quentin, 38054 GRENOBLE CEDEX 09 (FR); MICHIT, Nicolas, 38054 GRENOBLE CEDEX 09 (FR); PERNEL, Carole, 38054 GRENOBLE CEDEX 09 (FR); SIMON, Julia, 38054 GRENOBLE CEDEX 09 (FR); AUDIBERT, Margaux, 38054 GRENOBLE CEDEX 09 (FR); VIVARES, Valentin, 38054 GRENOBLE CEDEX 09 (FR)
(74) Mandataire: Cabinet Beaumont

(57) **Abrégé**

La présente description concerne un système émissif (100) comprenant une partie émissive (120), émettant à une première longueur d'onde, et une lentille (135) recouvrant la partie émissive (120), la lentille (135) et la partie émissive (120) étant en un même matériau III-V, de préférence choisi parmi le GaN, l'AlGaN, l'InGaN et l'InP, la lentille ayant une structure cœur-coquille avec une coquille (136) poreuse, moyennant quoi l'indice optique de la coquille (136) est différent de l'indice optique du cœur (137) de la lentille (135).

Le système émissif (100) est obtenu selon les étapes suivantes :
a) fournir une structure (100) comprenant une partie émissive (120) émettant à une première longueur d'onde et une lentille (135) recouvrant la partie émissive,
b) porosifier par voie électrochimique la coquille (136) de la lentille (135).

## Description

### Domaine technique

La présente description concerne de façon générale les systèmes émissifs et, plus particulièrement, dispositifs systèmes émissifs comprenant des (micro)lentilles.

### Technique antérieure

Les diodes électroluminescentes (DEL ou LED pour 'light-emitting diode') et les microLED (aussi notées µLED) à base d'InGaN/GaN ont été abondamment étudiées pour l'émission dans le spectre visible. Elles ont atteint un excellent degré de maturité grâce à leur utilisation dans le domaine de l'éclairage. La robustesse et la grande efficacité des LED GaN en font une solution privilégiée pour réaliser des micro-écrans de haute luminance et de haute résolution.

Outre l'optimisation de l'empilement semi-conducteur et des performances électro-optiques au sens large ('Internal Quantum Efficiency' (IQE)), il est critique de gérer au mieux les photons émis par les LED.

Le but est non seulement de minimiser les pertes par absorption et le bruit ('cross-talk') optique mais aussi d'extraire le maximum de lumière possible hors de la LED à la bonne longueur d'onde.

Par exemple, comme décrit dans la demande de brevet EP 4 521 891 A1, il est possible de contrôler la longueur d'onde émise par une LED en utilisant des mésas poreuses. En faisant varier le taux de porosité des mésas, il est possible de modifier le taux d'indium incorporé à la surface des mésas lors de l'épitaxie des LEDS et donc de contrôler les longueurs d'onde d'émission des LED épitaxiées.

L'utilisation de GaN poreux dans la fabrication de différentes structures de LED est aussi présentée, par exemple, dans la revue de Yao et al. ('The development and applications of nanoporous gallium nitride in optoelectronics: a review' (2023) Semicond. Sci. Technol. 38 074001).

Cependant, pour certaines applications (réalité augmentée (AR) / réalité virtuelle (VR), télécom par exemple), la directivité du faisceau lumineux émis par la LED est également un critère important.

Pour améliorer l'extraction et la directivité, il est possible d'optimiser le design de la LED (cavité, épaisseurs de l'empilement semiconducteur), mais également d'ajouter des éléments (micro)optiques sur la LED.

Parmi les éléments (micro)optiques pouvant être intégrés aux LED, citons notamment :
- les microlentilles afin d'améliorer l'extraction et éventuellement la directivité,
- les texturations de surface pour améliorer l'extraction (LEE pour 'Light Extraction Efficiency') notamment par rugosification et l'intégration de cristaux photoniques (extraction et directivité mais peu compatible avec les petits pas-pixel).

Les microlentilles sont généralement en un matériau diélectrique. Elles peuvent être réalisées par fluage d'une résine photosensible dans laquelle des motifs ont été formés par photolithographie, puis fluée et transférée par gravure dans un autre matériau (organique ou inorganique). Pour en maximiser la performance, elles sont en un même matériau que la microLED, ou à défaut en un matériau haut indice pour assurer une continuité d'indice (comme décrit dans la demande de brevet FR 3 157 672 A1).

Parmi les stratégies envisageables, on peut également citer celle décrite dans la demande de brevet US 2023/0282680 A1, qui propose un dispositif comprenant un empilement de couches de GaN porosifié pour extraire la lumière des microleds et pour améliorer l'isolation des pixels. Cependant, l'empilement formé augmente la taille du dispositif, ce qui ne les rend pas compatibles avec toutes les applications.

### Résumé de l'invention

Il existe un besoin d'avoir un système émissif présentant des propriétés optiques améliorées, notamment en ce qui concerne l'extraction et la directivité.

Ce but est atteint par un système émissif comprenant une partie émissive, émettant à une première longueur d'onde, et une lentille recouvrant la partie émissive, la lentille et la partie émissive étant en un même matériau III-V, de préférence choisi parmi le GaN, l'AlGaN, l'InGaN et l'InP, la lentille ayant une structure cœur-coquille avec une coquille poreuse, moyennant quoi l'indice optique de la coquille est différent de l'indice optique du cœur de la lentille.

Selon un mode de réalisation particulier, la première longueur d'onde est comprise entre 440 et 460 nm.

Selon un mode de réalisation particulier, le cœur de la lentille est poreux, le taux de porosité du cœur étant supérieur au taux de porosité de la coquille, des éléments de conversion spectrale étant insérés dans le cœur de la lentille, les éléments de conversion spectrale absorbant à la première longueur d'onde et émettant à une deuxième longueur d'onde supérieure à la première longueur d'onde.

Selon un mode de réalisation particulier, la lentille est creuse, le cœur de la lentille étant rempli par des éléments de conversion spectrale absorbant à la première longueur d'onde et émettant à une deuxième longueur d'onde supérieure à la première longueur d'onde.

Selon un mode de réalisation particulier, la deuxième longueur d'onde est comprise entre 520 et 700 nm.

Selon un mode de réalisation particulier, les éléments de conversion spectrale sont des quantum dots.

Selon un mode de réalisation particulier, la coquille poreuse présente un gradient du taux de porosité depuis une surface extérieur de la coquille vers le cœur de la lentille.

Ce but est également atteint par un procédé de fabrication d'un système émissif tel que défini précédemment, comprenant les étapes suivantes :
a) fournir une structure comprenant une partie émissive émettant à une première longueur d'onde et une lentille recouvrant la partie émissive, la lentille et la partie émissive étant en même un matériau III-V, de préférence choisi parmi le GaN, l'AlGaN, l'InGaN et l'InP,
b) porosifier par voie électrochimique au moins la coquille de la lentille, moyennant quoi la lentille a une structure cœur-coquille avec une coquille poreuse, l'indice optique de la coquille étant différent de l'indice optique du cœur de la lentille.

Selon un mode de réalisation particulier, l'étape de porosification est réalisée en appliquant un unique potentiel.

Selon un mode de réalisation particulier, l'étape de porosification est réalisée en appliquant un premier potentiel puis un deuxième potentiel, le premier potentiel étant différent du deuxième potentiel.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, la figure 2 et la figure 3 représentent, de manière schématique et en coupe, une partie d'un système émissif, selon différents modes de réalisation particuliers de l'invention ;
la figure 4A, la figure 4B, la figure 4C, la figure 4D, la figure 4E, la figure 4F et la figure 4G sont des vues en coupe illustrant des étapes d'un procédé de fabrication d'une structure optoélectronique à porosifier selon un mode de réalisation particulier de l'invention;
la figure 5A, la figure 5B, la figure 5C, la figure 5D et la figure 5E sont des vues en coupe illustrant des étapes d'un procédé de fabrication d'une structure optoélectronique à porosifier selon un autre mode de réalisation particulier de l'invention;
la figure 6A, la figure 6B, la figure 6C, la figure 6D, la figure 6E, la figure 6F et la figure 6G sont des vues en coupe illustrant des étapes d'un exemple d'un mode de réalisation d'un procédé de fabrication d'une structure optoélectronique à porosifier selon un autre mode de réalisation particulier de l'invention;
la figure 7A est un graphique représentant l'absorption d'une résine comprenant des boites quantiques ('quantum dots' ou QD) en fonction de la distance puits/miroir et de l'épaisseur de résine ramenée à l'équivalent du diamètre lentille (exemple comparatif) ;
la figure 7B est un graphique représentant l'absorption d'une lentille de GaN ayant une coquille porosifiée et un cœur porosifié dans lequel sont insérés des QD en fonction de la distance puits/miroir et du diamètre de la lentille selon un autre mode de réalisation particulier de l'invention ;
la figure 8A est un graphique représentant l'extraction d'une résine comprenant des QD en fonction de la distance puit/miroir et de l'épaisseur de résine ramenée à l'équivalent du diamètre lentille (exemple comparatif) ;
la figure 8B est un graphique représentant l'extraction d'une lentille de GaN ayant une coquille porosifiée et un cœur porosifié dans lequel sont insérés des QD en fonction de la distance puits/miroir et du diamètre de la lentille selon un autre mode de réalisation particulier de l'invention ;
la figure 9A est un graphique représentant l'extraction totale pour une LED à flancs droits recouvertes par des lentilles non porosifiées en fonction de l'étendue latérale du pixel et de la période du réseau de lentilles accolées à 530 nm (exemple comparatif) ;
la figure 9B est un graphique représentant l'extraction totale pour une LED à flancs droits recouvertes par des lentilles ayant une coquille porosifiée (présentant un gradient d'indice optique de 2.4 à 1.7 depuis l'extérieur de la coquille vers le cœur de la lentille) et un cœur non porosifié en fonction de l'étendue latérale du pixel et de la période du réseau de lentilles accolées à 530 nm selon un autre mode de réalisation particulier de l'invention.

Les différents éléments ne sont pas nécessairement représentés à une échelle uniforme pour rendre les figures plus lisibles.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Par système émissif, on entend un système qui émet de l'énergie sous forme de rayonnement électromagnétique (notamment la lumière visible, voire l'ultra-violet) dans son environnement. Le système émissif est, en particulier, une diode électroluminescente (DEL ou LED pour 'light emitting diode').

Sauf précision contraire, les expressions "environ", "approximativement", "sensiblement", et "de l'ordre de" signifient à 10 %, de préférence à 5 %.

Par compris entre X et Y, on entend que les bornes X et Y sont incluses.

Par longueur d'onde d'émission par exemple, on entend la longueur d'onde pour laquelle le spectre d'émission présente un pic d'intensité. A titre purement illustratif, les diodes électroluminescentes peuvent présenter un spectre d'émission dont le pic d'intensité est compris entre 380nm et 490nm.

Une diode électroluminescente comporte un empilement de différentes portions semiconductrices dopées, entre lesquelles se situe une zone active (formée des puits quantiques) émettant un rayonnement lumineux. Les diodes électroluminescentes peuvent être adaptées, par exemple, à émettre une lumière bleue, c'est-à-dire une lumière dont le spectre d'émission présente un pic d'intensité à une longueur d'onde comprise entre 440nm et 460nm environ. Les (micro)diodes électroluminescentes et les (micro)lentilles sont réalisées à base d'un même composé semiconducteur, par exemple à base d'un composé III-V tel que le GaN. Par réalisées à base de, on entend que les diodes électroluminescentes comportent majoritairement ce composé semiconducteur (correspondant aux couches semiconductrices dopées de part et d'autre de la zone active), même si d'autres composés sont présents dans la diode électroluminescente.

Par microlentille ou microLED (noté aussi µLED ou µlentille), on entend que les microlentilles ou les µLED ont une plus grande dimension inférieure à 10µm. Par la suite, même si la description fait référence à une lentille, il peut s'agir d'une microlentille (ou inversement) et/ou même si la description fait référence à une LED, il peut s'agir d'une microLED (ou inversement).

Les lentilles sont hémisphériques : elles ont la forme d'une demi-sphère. Une des faces de l'hémisphère est plane et forme un disque plat : il s'agit de la surface dite interne en contact avec la partie émissive 120. Une des faces de l'hémisphère est courbe (ou sphérique) et correspond à la surface dite externe.

Par une lentille cœur-coquille ('core-shell' en anglais), on entend que la lentille comprend deux zones distinctes : un noyau (le cœur) entouré par une enveloppe (la coquille). L'enveloppe suit le contour de la surface externe.

Par taux de porosification ou porosité, on entend le rapport entre le volume des pores par rapport au volume total d'un matériau.

Les éléments de conversion spectrale sont des éléments permettant de convertir au moins en partie la lumière d'excitation en une lumière d'émission de plus grande longueur d'onde. A titre illustratif, ils peuvent être adaptés pour absorber de la lumière bleue, c'est-à-dire dont la longueur d'onde est comprise entre 440 nm et 460 nm environ, et à émettre dans le vert, c'est-à-dire à une longueur d'onde comprise entre 520 nm et 530nm environ, voire dans le rouge, c'est-à-dire à une longueur d'onde comprise entre 630nm et 640 nm environ.

Dans la description qui va suivre, les mésas, aussi appelées élévations, sont des éléments en relief. La surface des mésas peut être circulaire, hexagonale, carrée ou rectangulaire. La plus grande dimension de la surface des mésas va de 500nm à 500µm. Par exemple, la plus grande dimension d'une surface circulaire est le diamètre. L'épaisseur des mésas correspond à la dimension de la mésa perpendiculaire à l'empilement sous-jacent. L'espacement entre deux mésas consécutives peut aller de quelques micromètres à quelques dizaines de micromètres. L'espacement va, de préférence, de 50nm à 20µm. Il est, par exemple, de 5 µm. Encore plus préférentiellement, il est compris entre 1 et 2µm.

L'invention est particulièrement intéressante pour la fabrication de micro-écrans. Les micro-écrans couleurs comprennent des pixels formés de sous-pixels bleus, verts et rouges (pixels RGB). Dans la suite de la description, ces sous-pixels seront désignés plus simplement pixel par souci de concision. Les pixels forment la partie émissive du système. Les pixels peuvent avoir une surface supérieure, inférieure ou égale à la surface interne de la lentille.

La partie émissive pourrait également être un VCSEL (pour « Vertical Cavity Surface Emitting Laser).

Nous allons maintenant décrire le procédé de fabrication du système émissif.

Le procédé comprend les étapes successives suivantes :
a) fournir une structure 100 comprenant une partie émissive (par exemple une LED ou µLED) 120 émettant à une première longueur d'onde et une lentille 135 recouvrant la partie émissive 120, la lentille 135 étant en un même matériau III-V que la partie émissive 120, le matériau III-V étant de préférence choisi parmi le GaN, l'AlGaN, l'InGaN et l'InP,
b) porosifier par voie électrochimique au moins la coquille 136 de la lentille 135, de manière à former une structure cœur-coquille, moyennant quoi l'indice optique de la coquille 136 est différent de l'indice optique du cœur 137 de la lentille 135.

La porosification permet de porosifier la surface externe de la lentille 135 (i.e. la surface en contact avec la solution électrolytique) et d'obtenir une lentille ayant une coquille 136 porosifiée.

La coquille 136 peut présenter un même taux de porosification depuis l'extérieur de la lentille 135 vers le cœur 137 de la lentille ou un gradient de porosification depuis l'extérieur de la lentille 135 vers le cœur 137 de la lentille (i.e. le gradient de porosification est radial). Le gradient est, par exemple, décroissant depuis l'extérieur de la lentille 135 vers le cœur 136 de la lentille. Il pourrait être croissant. La coquille 137 présente ainsi un gradient radial de porosité, et donc un gradient radial d'indice optique.

Avec de telles lentilles, l'indice optique est modifié orthogonalement à la surface externe courbe de la lentille 135 (non seulement verticalement par rapport à l'émission de la partie émissive 120 mais aussi radialement).

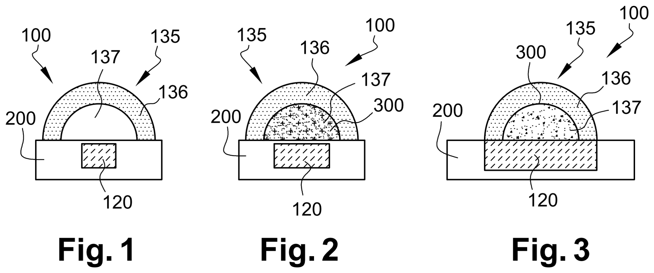

Selon une première variante de réalisation, représentée sur la figure 1, la porosification est réalisée en une seule étape. Seule la coquille 136 des lentilles est porosifiée. Le cœur 137 des lentilles n'est pas porosifié.

Cette variante de réalisation permet d'offrir des degrés de liberté supplémentaires pour améliorer l'extraction optique de l'ensemble formé de la LED et de la lentille 135. De plus, à performance optique égale, la lentille 135 porosifiée possède des dimensions plus facilement réalisables qu'une lentille non porosifiée.

Selon une deuxième variante de réalisation, la porosification est une porosification multipotentielle. La porosification est réalisée en plusieurs sous-étapes, par exemple en deux étapes (porosification dite à double potentiel) ou en plus de deux étapes, chacune des sous-étapes étant réalisée à un potentiel particulier. Le premier potentiel permet de porosifier la coquille 136 de la lentille 135 et le deuxième potentiel permet de porosifier le cœur 137 de la lentille (figure 2).

Le cœur 137 présente un taux de porosification supérieur, inférieur ou égale au taux de porosification de la coquille 136. De préférence, le taux de porosification du cœur 137 est supérieur au taux de porosification de la coquille 136. Le cœur 137 est fortement porosifié de manière à pouvoir y incorporer des éléments de conversion spectrale 300 (figure 2).

Lorsque le potentiel est suffisamment élevé, on se place en conditions d'électropolissage. Le cœur 137 de la lentille peut être gravé jusqu'à retirer tout le matériau III-V : on obtient une lentille creuse (figure 3). Le cœur 137 peut ensuite être rempli avec des éléments de conversion spectrale 300 (figure 3).

En ajoutant des éléments de conversion spectrale 300, par exemple des boites quantiques (QD ou 'quantum dots'), dans le cœur 137 des lentilles 135, on transfère la fonction de conversion dans les lentilles 135.

La lumière émise par la partie émissive 120 est convertie au sein de la lentille 135. La lentille 135 permet ainsi non seulement d'extraire les photons de la partie émissive 120 mais aussi de les convertir.

La coquille 136 présente une porosité suffisante pour permettre le passage des éléments de conversion spectrale 300 jusqu'au cœur 137 de la lentille 135. Autrement dit, la plus petite dimension des pores est supérieure à la plus grande dimension des éléments de conversion spectrale 300.

Nous allons maintenant décrire plus en détail les étapes a) et b) du procédé.

La structure fournie à l'étape a) peut être obtenue selon différents modes de réalisation particuliers.

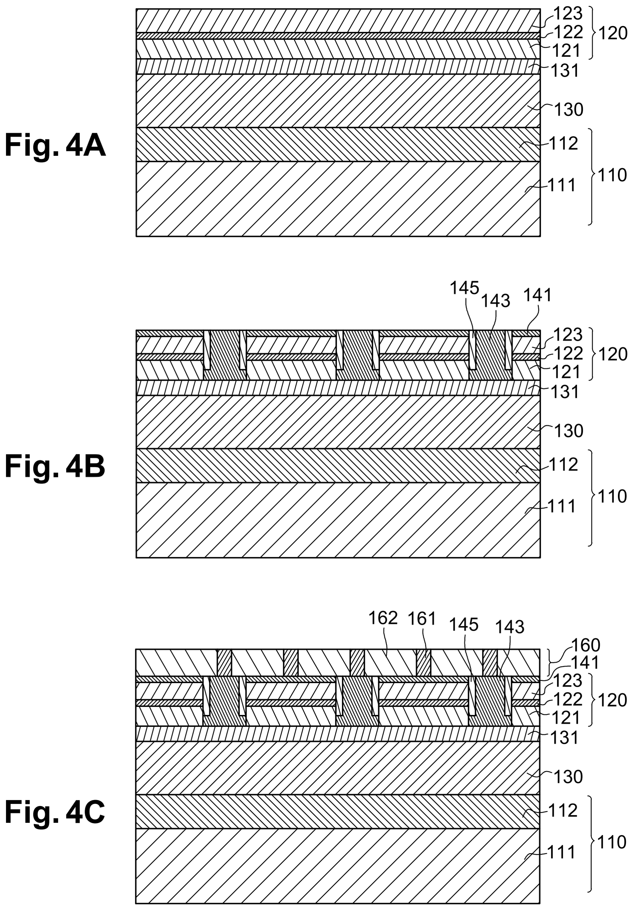

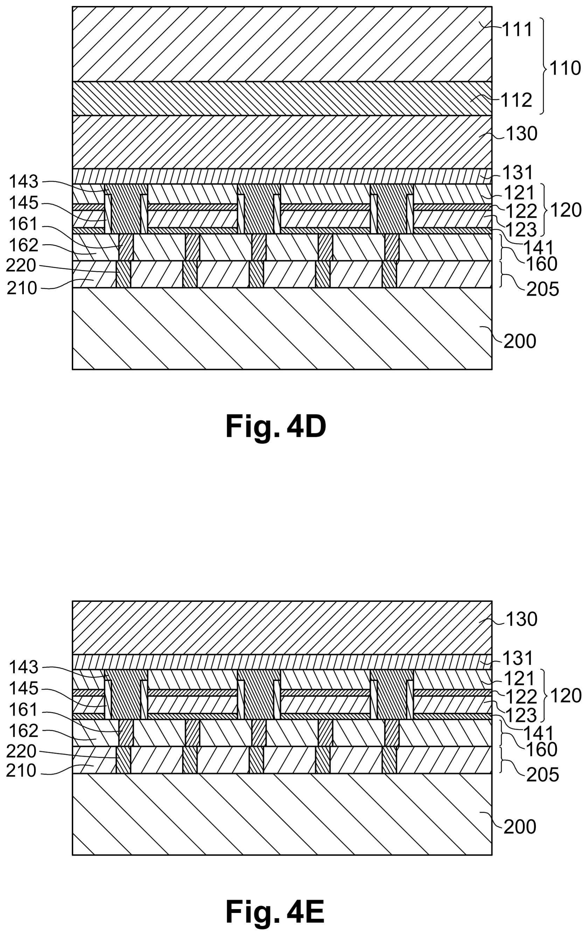

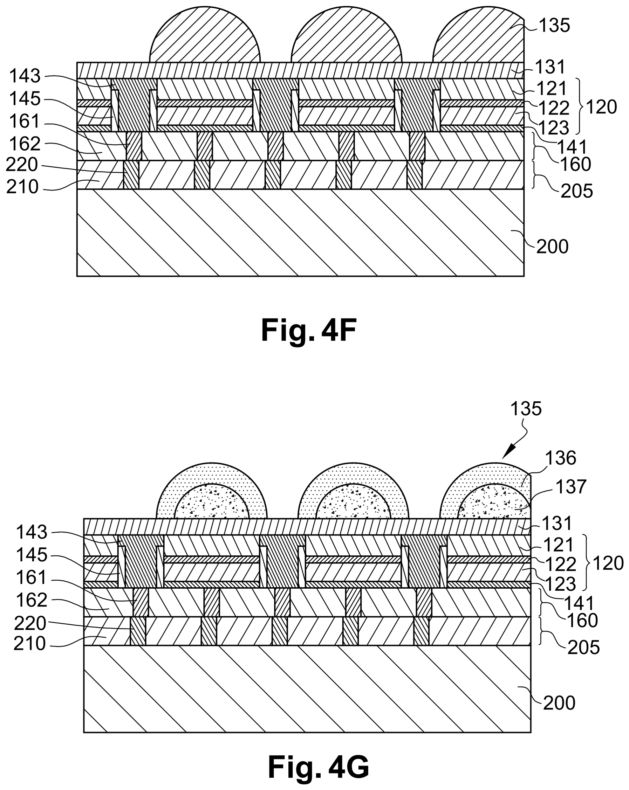

Selon un premier mode de réalisation particulier, par exemple représentée sur les figures 4A à 4E, la structure fournie à l'étape a) peut être obtenue selon les étapes suivantes :
- sur un substrat temporaire 110, recouvert par une couche de GaN n++ 130, et une couche de GaN nid 131, faire croître par épitaxie une structure LED 120 (figure 4A) ;
- déposer une première couche métallique 141, par exemple en titane, sur la structure LED 120 et former des tranchées à travers l'empilement 120 de couches épitaxiées jusqu'à la couche de couche de GaN n++ 130 ou jusqu'à la couche de GaN nid 131, puis remplir les tranchées par un métal 143, par exemple du titane ou du nitrure de titane, une couche de passivation 145 étant disposée entre le métal 143 et les couches de l'empilement 120 (figure 4B),
- former une couche métal/diélectrique 160 comprenant un matériau diélectrique 162 dans lequel sont formés des éléments de conduction 161, par exemple en cuivre, sur la couche métallique 141 et sur le métal 143 (figure 4C),
- coller l'ensemble obtenu sur le substrat hôte 200 (de préférence de type ASIC) recouvert par une autre couche métal/diélectrique 205 comprenant un matériau diélectrique 210 dans lequel sont formés des éléments de conduction 220, le collage étant un collage hybride (figure 4D),
- retirer le substrat temporaire 110, par exemple par polissage ('grinding'), gravure chimique ou procédé électrochimique (figure 4E),
- former des lentilles 135 dans la couche de GaN++ 130 ('patterning') par exemple par un procédé de photolithographie (dépôt résine, fluage, gravure) (figure 4F).

Les lentilles sont ensuite porosifiées selon le procédé précédemment décrit (figure 4G). L'étape de porosification peut être réalisée en prenant contact :
- soit sur le substrat hôte 200 (i.e. *via* le circuit de lecture du substrat hôte 200),
- soit en bord de dispositif (par exemple ici en bord de plaque) sur la couche métallique 141 ou sur la couche de N GaN 130 si celle-ci n'est pas gravée sur toute son épaisseur.

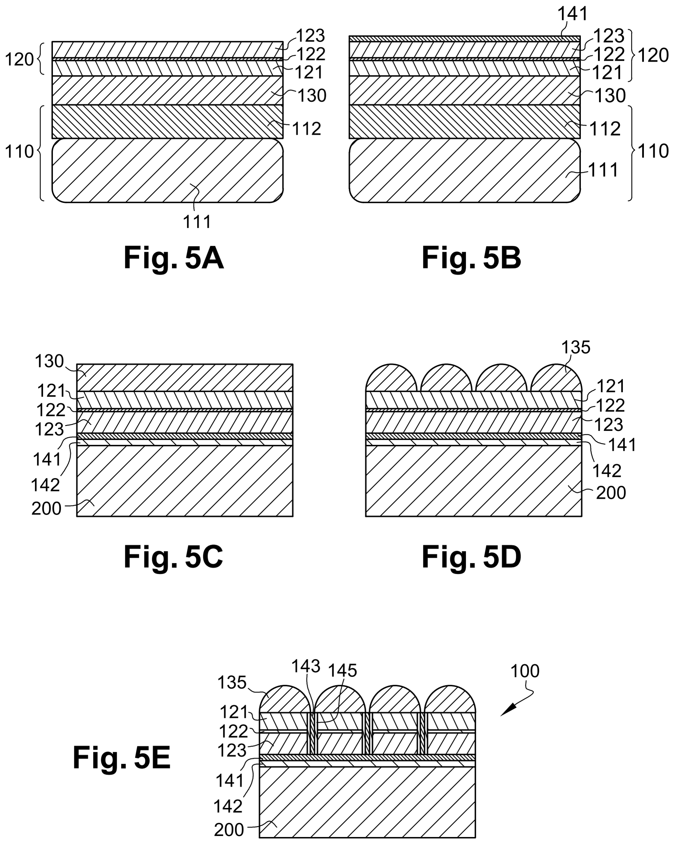

Selon une autre variante de réalisation, par exemple représentée sur les figures 5A à 5E, une première couche métallique 141, par exemple en titane, est déposée sur la structure LED 120 (figure 5B) et une deuxième couche métallique 142, par exemple en titane, recouvre le substrat hôte 200. Le collage est un collage métal/métal, de préférence un collage Ti/Ti (figure 5C).

Selon une variante de réalisation, par exemple représentée sur la figure 5E, la formation des tranchées et leur remplissage 143 peuvent être réalisés après le collage du substrat hôte 110 et du substrat temporaire 200 (avant ou après la formation des lentilles 135).

L'étape de porosification électrochimique se fait via le circuit de lecture du substrat hôte 200 ou via l'une des couches métalliques 141, 142 (figure 5E).

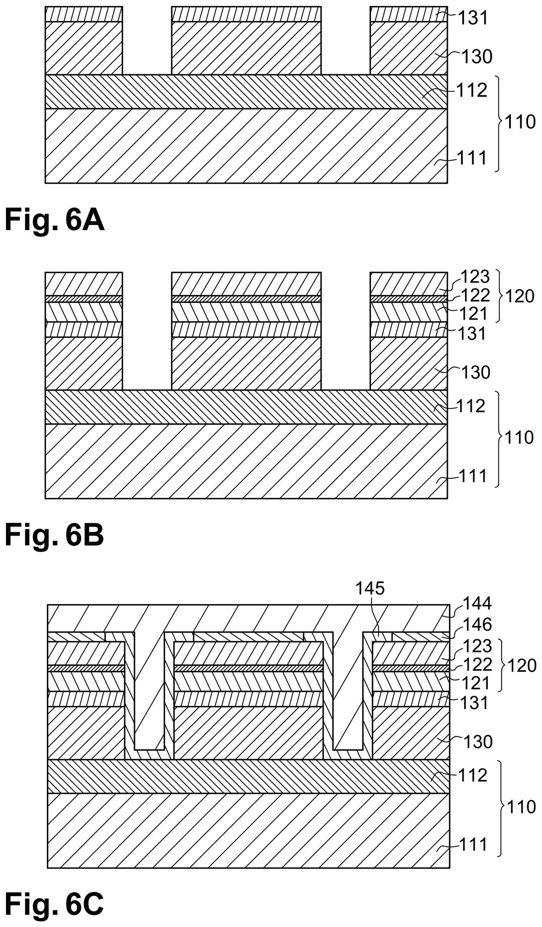

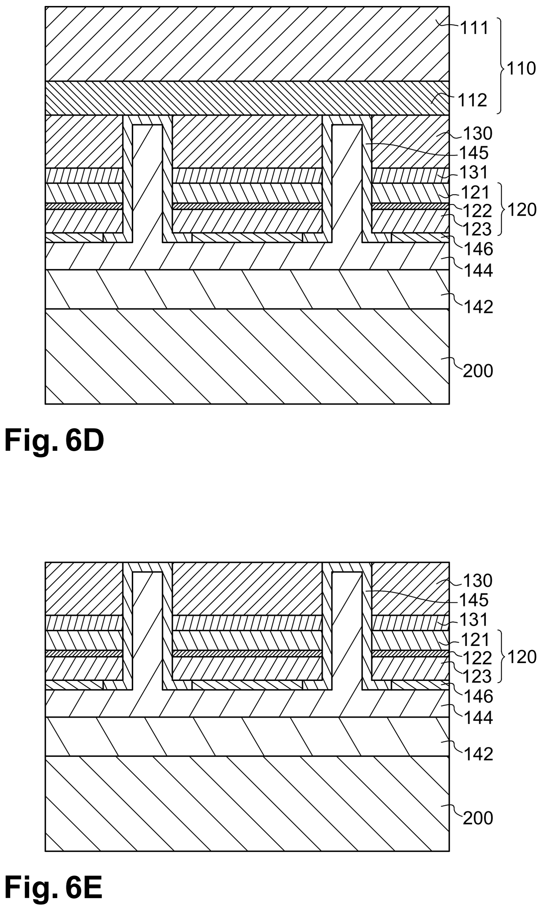

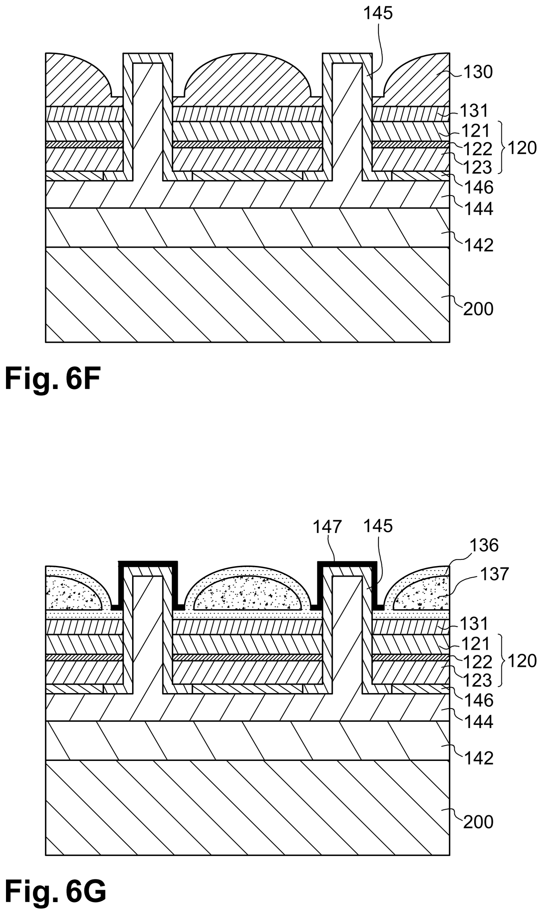

Selon un deuxième mode de réalisation particulier, par exemple représentée sur les figures 6A à 6G, la structure fournie à l'étape a) peut être obtenue selon les étapes suivantes :
- sur un substrat temporaire 110, déposer une couche de GaN n++ 130 et une couche de GaN nid 131, puis structurer la couche de GaN n++ 130 et la couche de GaN nid 131 pour former des mésas (figure 6A),
- faire croître par épitaxie une structure LED 120 sur les mésas (figure 6B),
- recouvrir le flanc des mésas par une couche électriquement isolante 145, déposer une couche métallique 146, jouant le rôle de couche d'amorce puis déposer un métal 144 (par exemple du titane) entre les mésas et sur les mésas (figure 6C),
- coller l'ensemble obtenu sur un substrat hôte 200, pouvant être recouvert par une couche métallique 142, par exemple en titane, au moyen d'un collage métal/métal, de préférence un collage Ti/Ti (figure 6D),
- retirer le substrat temporaire 100, par exemple par polissage ('grinding'), gravure chimique ou procédé électrochimique (figure 6E),
- former des lentilles 135 dans la couche de GaN++ 130 ('patterning') par exemple par un procédé de photolithographie (dépôt résine, fluage, gravure) (figure 6F).

L'étape de porosification électrochimique se fait via le circuit de lecture du substrat hôte 200 ou via l'une des couches métalliques 142, 144, 146 ou le n-GaN 130 (figure 6G).

Il est ainsi possible d'adapter la microlentille à la longueur d'onde de la microled. L'ajustement de la porosité de la microlentille en fonction de la longueur d'onde émise par le pixel permet d'optimiser l'extraction en accordant la cavité.

Dans les différents modes de réalisation particuliers précédemment décrits (figure 4A, 5A ou 6A), le substrat temporaire 110 (ou substrat de croissance) comprend un substrat support 111 et éventuellement une couche tampon 112 ('buffer layer'). En pratique, selon la nature du substrat 110, un empilement plusieurs couches tampon peuvent faire interface entre le substrat support 111 et la couche de nitrure de gallium 130. Une couche tampon 112 peut être par exemple en (Al,Ga)N dans le cas d'un substrat en silicium. Le substrat support 111 est par exemple un substrat en silicium, en saphir, en corindon.

Une couche de GaN dopée (couche de GaN n++) 130 dans laquelle sera formée les lentilles 135 est formée sur le substrat 100.

Selon le premier mode de réalisation, l'empilement 120 est formé pleine plaque sur la couche de GaN 130 ou sur une couche de GaN nid 131 recouvrant la couche de GaN(figures 4A, 5A).

Selon le deuxième mode de réalisation, la couche de GaN n++ 130 est recouverte par une couche de GaN nid 131, puis ces couches sont structurées sous forme de mésas (figure 6A) avant de former l'empilement 120 (figure 6B) Le procédé comprend alors une étape au cours de laquelle des tranchées sont formées dans la couche de GaN n ++ 130 et dans la couche de GaN nid 131. Les mésas sont obtenues, par exemple, par gravure d'une couche continue ou de plusieurs couches continues superposées, de manière à ne laisser subsister qu'un certain nombre de "reliefs" de cette couche ou de ces couches. L'étape de structuration est, par exemple, réalisée par lithographie puis gravure.

La LED forme un empilement actif 120. Il s'agit de la partie émissive. La LED est, par exemple, déposée par épitaxie sur la face supérieure couche de GaN n++ 130 (figure 5A) ou sur la couche GaN nid 131 (figures 4A, 6B).

Dans les exemples représentés, l'empilement actif 120 comprend, dans l'ordre à partir de la surface supérieure de la couche de GaN n++ 130 ou de la couche de de GaN nid 131, une couche de nitrure de gallium dopé de type N 121, une couche émissive 122, et une couche de nitrure de gallium dopé de type P 123. La couche émissive 122 est par exemple constituée par un empilement d'une ou plusieurs couches émissives formant chacune un puit quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, la couche émissive 122 peut être une couche de nitrure de gallium intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³. Dans cet exemple, la face inférieure de la couche émissive 122 est en contact avec la face supérieure de la couche 121, et la face supérieure de la couche émissive 122 est en contact avec la face inférieure de la couche 123. A titre d'exemple, l'épaisseur de l'empilement actif 120 est comprise entre 0,5 et 2 µm.

La couche de GaN n++ 130 est en un même matériau que la partie émissive 120 pour assurer une continuité d'indice optique.

La figure 5B ou 6C illustre une étape de dépôt, sur la face supérieure de l'empilement actif de diode au nitrure de gallium 120, d'une couche métallique 141. Dans l'exemple représenté sur la figure 5B, la couche métallique 141 est disposée sur et en contact avec la face supérieure de la couche de nitrure de gallium 123. La couche métallique 141 revêt par exemple sensiblement toute la surface supérieure de l'empilement actif.

Dans le cas où la structure comporte des mésas, un métal 144, par exemple du cuivre, est déposé entre les mésas (figure 6C). Une couche d'amorce 146 est, de préférence, déposée préalablement au dépôt de la couche métallique 144 pour faciliter le dépôt de cette dernière. La couche d'amorce 146 peut être déposée pleine plaque (figure 6C).

Pour éviter le court-circuit P-N, une couche de passivation 145 est formée le long des flancs de la jonction PN dans la tranchée, avant le dépôt de la couche d'amorce 146 ou de la couche métallique 144.

La figure 4D, la figure 5C et la figure 6D illustrent une étape au cours de laquelle l'empilement actif de LED 120 est rapporté sur un substrat hôte 200.

Le substrat hôte (ou substrat receveur) 200 est, par exemple, un substrat en matériau semiconducteur, du silicium notamment, dans lequel un circuit intégré de contrôle est formé. En particulier, le circuit de contrôle comprend, du côté de sa face supérieure, pour chacune des LEDs du dispositif, un plot métallique de connexion destiné à être connecté à l'une des électrodes (anode ou cathode) de la LED, de façon à pouvoir commander un courant circulant dans la LED et/ou appliquer une tension aux bornes de la LED. Le circuit de contrôle comprend par exemple, pour chaque LED, connectée au plot métallique dédié à la LED, une cellule élémentaire de contrôle comportant un ou plusieurs transistors, permettant de contrôler le courant circulant dans la LED et/ou une tension appliquée aux bornes de la LED. Le circuit de contrôle est par exemple réalisé en technologie CMOS. Les plots métalliques peuvent être latéralement entourés par un matériau isolant, par exemple de l'oxyde de silicium, de façon que le circuit de contrôle présente une surface supérieure sensiblement plane comprenant une alternance de régions métalliques et de régions isolantes. Le contact sur les électrodes des LEDs (cathodes ou anodes) non connectées aux plots, peut être pris de façon collective, par exemple dans une région périphérique du circuit de contrôle, par l'intermédiaire d'un ou plusieurs plots de connexion (non visibles sur la figure) du circuit de contrôle.

Une couche métallique 142 peut être déposée sur la face supérieure du substrat hôte 200 (figure 5C). Dans l'exemple représenté, la couche métallique 142 revêt sensiblement toute la surface supérieure du substrat hôte 200. En particulier, la couche métallique 142 est en contact avec les plots métalliques 220 de connexion du circuit de contrôle. Il peut également s'agir d'une couche 205 diélectrique / métal (figure 4D).

Alternativement, le substrat hôte 200 peut ne pas être recouvert par une couche métallique et le collage se fait directement sur la face supérieure du substrat 200.

Pour réaliser l'étape de report, l'ensemble comportant le substrat temporaire 110 et l'empilement actif 120 peut être retourné, puis rapporté sur le substrat hôte 200, de façon à mettre en contact, par exemple :
- la couche métal/diélectrique 160 en contact avec la couche métal/diélectrique 205 (figure 4D),
- la couche métallique 141/144 et la couche métallique 142 recouvrant le substrat hôte 200 (figure 5C ou 6D).

Au cours de cette étape, l'empilement actif 120 est fixé ('bonded') au circuit de contrôle. A titre d'exemple, la fixation de l'empilement actif 120 sur le circuit de contrôle peut être obtenue par collage moléculaire, de préférence par collage hybride, entre les deux surfaces mises en contact. A titre de variante, la fixation des deux surfaces peut être réalisée par thermocompression ou collage eutectique.

Le substrat support 110 de l'empilement actif de LED 120 est retiré de façon à découvrir la face supérieure de la couche de nitrure de gallium 123 (figures 4C, 5D, 6E). Le substrat support 110 est par exemple retiré par meulage ('grinding') et/ou gravure à partir de sa face opposée à l'empilement actif 120. A titre de variante, dans le cas d'un substrat support 110 transparent, par exemple un substrat en Al₂O₃ monocristallin, par exemple, du saphir ou en corindon, le substrat support 110 peut être détaché de l'empilement actif 120 au moyen d'un faisceau laser projeté à travers le substrat 151 depuis sa face opposée à l'empilement actif 120 (procédé de type laser 'lift-off'). Plus généralement, toute autre méthode permettant de retirer le substrat support 110 peut être utilisée. Après le retrait du substrat, une étape supplémentaire de gravure peut être prévue pour retirer d'éventuelles couches tampon subsistant du côté de la face supérieure de la couche de nitrure de gallium 130. En outre, une partie de l'épaisseur de la couche de nitrure de gallium 130 peut être retirée, par exemple par gravure.

Une couche de passivation 145 peut ensuite être formée sur le métal 144 entre les mésas (figure 6C).

Une étape de formation de lentilles est ensuite réalisée dans la couche de GaN 130 (figure 4F, 5D et 6F). L'étape peut être réalisée par photolithographie. Par exemple, les microlentilles sont réalisées par fluage d'une résine photosensible dans laquelle des motifs ont été faits par photolithographie, puis fluée et transférée par gravure.

La couche de GaN est structurée de manière à former des lentilles hémisphériques. La surface plane des lentilles peut être inférieure, égale ou supérieure à la surface des lentilles. Par exemple, la surface plane de la lentille peut être deux fois plus importante que la surface du pixel.

Dans le système émissif obtenu (figures 4F, 5E et 6G) à porosifier, chaque LED correspond à un îlot ou mesa formé dans l'empilement et entouré latéralement par une tranchée. Les tranchées s'étendent verticalement sur toute la hauteur de l'empilement 120. Ainsi, chaque LED comprend un empilement vertical comportant, dans l'ordre à partir de la surface supérieure de la couche métallique 141/146 : une portion de la couche de nitrure de gallium 123, correspondant à l'anode de la LED dans ces exemples, une portion de la couche émissive 122, et une portion de la couche de nitrure de gallium 121, correspondant à la cathode de la LED dans ces exemples. Les tranchées peuvent être disposées de manière à ce que chaque LED soit située, en projection verticale, en regard d'un unique plot métallique du circuit de contrôle (non représenté ici). La couche métallique 141/146 peut servir de reprise de contact lors la porosification.

A l'issue de l'étape a), l'étape b) de porosification des lentilles 135 peut ensuite être mise en œuvre.

Comme indiqué précédemment, l'étape de porosification peut être mise en œuvre en une étape ou en plusieurs sous-étapes pour former des lentilles 135 réfractives au moins partiellement poreuse.

Lors de l'étape b), les lentilles 135 sont partiellement ou totalement porosifiées.

La porosification peut être réalisée selon les sous-étapes suivantes :
- relier électriquement la structure et une contre-électrode à un générateur de tension ou de courant,
- plonger la structure et la contre-électrode dans une solution électrolytique,
- appliquer au moins une tension ou un courant entre les lentilles 135 et la contre-électrode de manière à porosifier la coquille des lentilles.

La structure et la contre-électrode (CE) sont électriquement reliées à un générateur de tension ou de courant. Le dispositif joue le rôle d'électrode de travail (WE). Par la suite, on le dénommera générateur de tension, mais il pourrait s'agir d'un générateur de courant permettant d'appliquer un courant entre le dispositif et la contre-électrode.

Comme mentionné précédemment, la prise de contact est réalisée sur la structure, sur un des bords de la structure, au niveau des couches métalliques 141, 142, 144 ou de la couche de GaN 130, ou *via* le substrat hôte 200.

La contre-électrode est en un matériau électriquement conducteur, comme par exemple un métal de grande surface développée et inerte à la chimie de l'électrolyte tel qu'un grillage en platine.

Les électrodes sont plongées dans un électrolyte, aussi appelé bain électrolytique ou solution électrolytique. L'électrolyte peut être acide ou basique. L'électrolyte est, par exemple, à base d'acide oxalique. Il peut également s'agir de KOH, HF, HNO₃, NaNO₃ ou H₂SO₄. Il peut s'agir d'un mélange d'acide oxalique et de NaNO₃.

La tension appliquée entre la structure 100 et la contre-électrode peut aller, par exemple, de 1 à 100V, de préférence de 1 à 30V par exemple. De préférence, elle est de 5 à 15V, et encore plus préférentiellement de 6 à 12V, par exemple de 8 à 10V. La tension est choisie en fonction des taux de dopage des différentes couches, afin d'obtenir la sélectivité recherchée. Elle est appliquée, par exemple, pendant une durée allant de quelques secondes à plusieurs heures. La porosification est complète lorsqu'il n'y a plus de courant à un potentiel imposé. A ce moment-là, toute la structure dopée est porosifiée et la réaction électrochimique s'arrête.

Par exemple, l'étape de porosification est réalisée en appliquant une tension de 9V (non pulsé) dans une solution d'acide oxalique.

L'étape d'anodisation électrochimique peut être réalisée sous lumière ultra-violette (UV).

La porosification obtenue (taux de porosité et taille des pores) dépend du dopage de la lentille 135 et des paramètres du procédé (tension appliquée, durée, nature et concentration de l'électrolyte, post-traitement chimique ou recuit). En effet, à taux de dopage constant, en fonction du potentiel appliqué, des taux de porosité, tailles de pores et densités différents sont obtenus.

En appliquant un unique potentiel pendant une durée suffisamment courte, il est possible de porosifier uniquement la coquille 136 des lentilles 135. La porosification commence sur les bords de la lentille de manière homogène. Plus la durée augmente et plus l'épaisseur de la partie porosifiée augmente. L'étape de porosification est arrêtée avant porosification totale des lentilles 135.

La mise en œuvre d'une étape porosification en plusieurs étapes, avec différents potentiels, permet d'obtenir des lentilles structurées présentant plusieurs parties différemment porosifiées.

Le premier potentiel est, de préférence, inférieur au deuxième potentiel.

A faible potentiel, le taux de porosité et la taille des pores sont faibles. Il s'agit d'un régime de nucléation, conduisant à la création de canaux. Les canaux sont créés à partir de la surface externe des lentilles 135, c'est-à-dire à partir de la surface en contact avec la solution électrolytique.

A plus fort potentiel, le régime de porosification, voire le régime d'électropolissage, est atteint : la porosification se propage dans les zones les plus conductrices (autrement dit, dans la partie centrale 137 de la lentille 135 qui n'a pas encore été impliquée dans les réactions électrochimiques, consommatrices de charges).

Le taux de porosité du cœur 137 de la lentille 135 peut être supérieur au taux de porosité de la coquille 136. Il est ainsi possible d'y introduire ensuite des éléments de conversion de couleur tel que des QDs.

Dans le cas d'une lentille poreuse sans fonction de conversion, le taux de porosité du cœur 137 de la lentille 135 peut être inférieur au taux de porosité de la coquille 136.

A l'issue de l'étape b) de porosification, le taux de porosité de la coquille 136 est, avantageusement, d'au moins 10%. Il va de préférence de 25% à 70%, de préférence de 25% à 50%, par exemple 45% 50%.

La plus grande dimension (la hauteur) des pores peut varier de quelques nanomètres à quelques micromètres (par exemple jusqu'à la hauteur maximale de la lentille). La plus petite dimension (le diamètre) peut varier de quelques nanomètres à une centaine de nanomètres, en particulier entre 15 et 70nm.

Lorsque le cœur 137 de la lentille 135 est vide ou poreux, le procédé peut comporter une étape ultérieure au cours de laquelle le cœur 137 de la lentille 135 est rempli partiellement ou totalement d'éléments de conversion spectrale 300. Cette étape peut être réalisée en mettant le système avec un fluide (liquide de préférence) contenant les éléments convertisseurs de lumière.

Les éléments de conversion spectrale 300 peuvent être des fluorophores ou des boites quantiques (QD).

Les QD peuvent être choisis, par exemple, parmi CdSe/ZnS, ZnCdSe, CdZnS, InP, InP/ZnSe/ZnS et InP/ZnS.

Les éléments de conversion spectrale 300 absorbent à une première longueur (celle émise par la partie émissive 120) et émettent à une deuxième longueur d'onde. La deuxième longueur d'onde est supérieure à la première longueur d'onde.

Par exemple, la première longueur d'onde est dans le bleu et la deuxième longueur d'onde est dans le rouge.

Des modes de réalisation particuliers ont été décrits. Diverses variantes et modifications apparaîtront à l'homme de l'art. En particulier, les types de conductivité des couches de nitrure de gallium 121 (de type N dans les exemples décrits) et 124 (de type P dans les exemples décrits) peuvent être inversés.

Plus généralement, les modes de réalisation décrits peuvent être adaptés à la fabrication de tout dispositif d'affichage ou capteur photosensible à base de diodes semiconductrices, y compris à base de matériaux semiconducteurs autres que le nitrure de gallium, par exemple des diodes à base d'autres matériaux semi-conducteurs III-V ou des diodes à base de silicium.

### Exemples illustratifs et non limitatifs

### 1^{er} exemple

Dans ce premier exemple, nous allons comparer, au moyen d'une simulation 2D, les caractéristiques d'une lentille ayant une coquille poreuse et un cœur poreux rempli de quantum dots (matrice d'indice n=1.7+0.008i) et les caractéristiques d'une couche uniforme de QD positionnée au-dessus de la LED.

Pour normaliser les résultats, nous avons converti l'épaisseur de la couche uniforme de manière à ce que le même nombre de QD soient présents que dans le cas avec lentille. L'épaisseur de couche uniforme de QD est donc exprimée en un diamètre équivalent de lentille. De cette manière, il est plus aisé de comparer les absorptions par QD dans les deux cas.

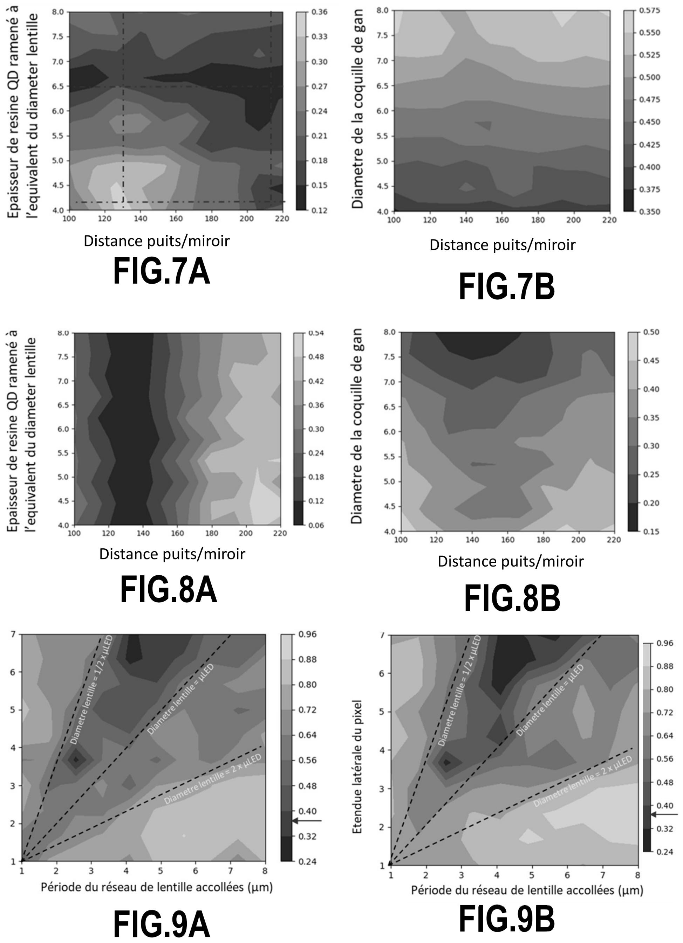

Dans le cas sans lentille, la cavité est dominée par un effet Fabry Pérot de l'empilement horizontal : ainsi l'absorption dans les QD dépend du la distance puits quantique/métal réflecteur et de la hauteur de la couche de conversion. Dans la meilleure configuration, une absorption de 30% est atteinte, pour une distance puit/miroir de 130nm (figure 7A).

A l'ajout de la lentille au-dessus de la LED, les interférences par Fabry Pérot s'atténuent et l'absorption dans les QD ne dépend plus que du diamètre de la lentille qui peut être maximisé. Avec un diamètre de 8µm l'absorption des QD atteint 60%, ce qui est bien supérieur au résultat sans lentille (figure 7B).

L'absorption des QD est importante car d'elle dépend la quantité de lumière convertie réémise. La simulation sur la réémission des QD est fastidieuse à cause de la source répartie dans toute la couche de conversion mais les résultats s'intuitent assez facilement. La réémission à l'intérieur de la lentille est largement facilitée par la structure d'extraction, tandis que dans une couche uniforme elle se cantonne à l'émission dans le cône de lumière de l'interface air/matrice QD. Autrement dit, tant pour la partie absorption qu'émission, la solution avec la lentille apporte des performances intéressantes.

Enfin, dans une couche de conversion, il est important d'émettre de la lumière mais il est aussi important de ne pas laisser passer la lumière d'excitation qui viendrait polluer le spectre d'émission converti. Nous regardons donc la quantité de lumière bleue qui passe à travers la couche de QD pour créer une diaphonie sur le système final : cette quantité de lumière doit donc être minimisée. Dans le cas sans lentille, nous retrouvons le Fabry Pérot avec pour interférence principale celle causée par la distance miroir/puit. A 130nm de distance, l'absorption était maximale dans les QD et la transmission de lumière est minimale, autour des 10%. L'ajout de la lentille vient diminuer ces effets et la lumière bleue peut plus facilement être extraite ce qui augmente la diaphonie vers un minimum de 15-20% dans le cas où la lentille possède un grand diamètre. Cette diaphonie plus importante peut être combattue avec des couches antireflet ou des QD plus absorbants, voire incluant des particules diffusantes.

### 2^{nd} exemple

Dans ce second exemple, la structure cœur/coquille de la lentille comprend un cœur non porosifié et une coquille porosorifiée.

La simulation de la source LED incohérente a été réalisée sous Lumerical ANSYS en FDTD. Les figures de cette partie sont des cartographies de puissance optique (ou d'absorption) dans l'espace (figures 8A et 8B). Les simulations de sources incohérentes ont été réalisées en 2D, ce qui permet d'obtenir les informations importantes tout en allant plus rapidement qu'une représentation en 3D. Les cartographies réalisées sont un peu bruitées mais les informations obtenues restent néanmoins suffisamment claires. Les valeurs exprimées d'extraction ou d'absorption sont données à titre d'illustration et dépendent des hypothèses faites sur les matériaux et la géométrie simulée.

Pour les simulations optiques, on considère ici une lentille de GaN intégrée au-dessus d'une µLED. Comme tel, la lentille du système améliore déjà l'extraction optique par rapport à une µLED sans lentille. La lentille est porosifiée pour modifier localement son indice optique et augmenter ainsi ses performances optiques. La porosification se fait de manière conforme à la surface de la lentille. En appliquant un gradient temporel d'amplitude du voltage aux bornes des électrodes, un gradient de densité de porosification se crée au sein de la lentille en GaN, et donc un gradient d'indice optique. Typiquement, une succession de créneaux temporel sur la tension de porosification transfère une série de coquilles concentriques d'indice différent dans la lentille.

Ce degré de liberté supplémentaire permet d'améliorer les performances optiques du dispositif.

Pour illustrer cette affirmation, nous comparons des dispositifs sans ou avec porosification de la lentille intégrée au-dessus d'un pixel (figures 8A et 8B). La valeur d'intérêt est l'extraction optique au-dessus du système et nous cherchons à la maximiser. La forme temporelle de la tension appliquée est un escalier qui forme une série de 8 coquilles d'épaisseur 100nm et d'indice optique [2.4 ; 2.3 ; 2.2 ; 2.1 ; 2.0 ; 1.9 ; 1.8 ; 1.7]. Cette forme de porosification progressive est un exemple de ce qui peut être réalisé. Pour optimiser les performances, il faudrait modifier les couples épaisseur/indice de chaque couche au moyen d'un algorithme d'optimisation à même de traiter ce nombre de paramètres.

Les figures 9A et 9B représentent l'extraction optique simulée d'une lentille (ou d'un réseau de lentille accolées) de diamètre compris entre 1 et 8µm intégrée au-dessus d'un pixel d'étendue comprise entre 1 et 7µm.

Les performances optiques sont meilleures dans le cas utilisant la porosification de la lentille avec une extraction maximale importante (zone claire). Il faut noter que l'extraction optique du couple pixel/lentille est dépendante du rapport entre les deux longueurs caractéristiques. On choisira, avantageusement, de disposer une lentille de grande dimension au-dessus d'un pixel de petite dimension ou bien d'un réseau de lentilles de petites dimensions au-dessus d'un pixel de grande dimension. Les lentilles utilisées ont, par exemple, un diamètre supérieur à 1µm et inférieur à 6um. De telles lentilles peuvent être fabriquées facilement de manière industrielle.

A cet égard la solution avec porosification de la lentille permet de conserver les performances optiques d'une lentille non porosifiée et de changer ses dimensions pour les rendre plus facilement fabricable. Ainsi le niveau de performance atteint pour un petit pixel (<2µm) et une lentille non porosifiée de 6µm de diamètre peut être atteint par une lentille porosifiée de 4µm de diamètre pour un petit pixel mais également par une lentille de 1µm pour des pixels plus grands.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Système émissif (100) comprenant une partie émissive (120), émettant à une première longueur d'onde, et une lentille (135) recouvrant la partie émissive (120), la lentille (135) et la partie émissive (120) étant en un même matériau III-V, de préférence choisi parmi le GaN, l'AlGaN, l'InGaN et l'InP, la lentille ayant une structure cœur-coquille avec une coquille (136) poreuse, moyennant quoi l'indice optique de la coquille (136) est différent de l'indice optique du cœur (137) de la lentille (135), la lentille (135) étant une lentille hémisphérique.

2. Système selon la revendication 1, dans lequel la première longueur d'onde est comprise entre 440 et 460 nm.

3. Système selon l'une des revendications 1 et 2, dans lequel le cœur (137) de la lentille (135) est poreux, le taux de porosité du cœur (137) étant supérieur au taux de porosité de la coquille (136), des éléments de conversion spectrale (300) étant insérés dans le cœur (137) de la lentille (135), les éléments de conversion spectrale (300) absorbant à la première longueur d'onde et émettant à une deuxième longueur d'onde supérieure à la première longueur d'onde.

4. Système selon l'une des revendications 1 et 2, dans lequel la lentille (135) est creuse, le cœur (137) de la lentille (135) étant rempli par des éléments de conversion spectrale (300) absorbant à la première longueur d'onde et émettant à une deuxième longueur d'onde supérieure à la première longueur d'onde.

5. Système selon l'une des revendications 3 ou 4, dans lequel la deuxième longueur d'onde est comprise entre 520 et 700 nm.

6. Système selon l'une des revendications 3 à 5, dans lequel les éléments de conversion spectrale (300) sont des quantum dots.

7. Système selon l'une des revendications précédentes, dans lequel la coquille (136) poreuse présente un gradient du taux de porosité depuis une surface extérieur de la coquille (136) vers le cœur de la lentille (135).

8. Procédé de fabrication d'un système émissif (100) selon l'une des revendications 1 à 7, comprenant les étapes suivantes :
a) fournir une structure (100) comprenant une partie émissive (120) émettant à une première longueur d'onde et une lentille (135) recouvrant la partie émissive, la lentille (135) et la partie émissive (120) étant en même un matériau III-V, de préférence choisi parmi le GaN, l'AlGaN, l'InGaN et l'InP, la lentille (135) étant une lentille hémisphérique,
b) porosifier par voie électrochimique au moins la coquille (136) de la lentille (135), moyennant quoi la lentille a une structure cœur-coquille avec une coquille (136) poreuse, l'indice optique de la coquille (136) étant différent de l'indice optique du cœur (137) de la lentille (135).

9. Procédé selon la revendication 8, dans lequel l'étape de porosification est réalisée en appliquant un unique potentiel.

10. Procédé selon la revendication 8, dans lequel l'étape de porosification est réalisée en appliquant un premier potentiel puis un deuxième potentiel, le premier potentiel étant différent du deuxième potentiel.
